# EUROPÄISCHE PATENTANMELDUNG

(11) **EP 1 727 190 A1**
(43) Veröffentlichungstag der Anmeldung: **29.11.2006**
(21) Anmeldenummer: 06010298.5
(22) Anmeldetag: 18.05.2006
(51) Int. Cl.: H01L 21/265

(54) **Halbleiter-Schichtstruktur und Verfahren zur Herstellung einer Halbleiter-Schichtstruktur**

(30) Priorität: 25.05.2005 DE 102005024073
(71) Anmelder: Siltronic AG, 81737 München (DE)
(72) Erfinder: Murphy, Brian, 84347 Pfarrkirchen (DE); Häberlen, Maik, 86159 Augsburg (DE); Lindner, Jörg, Dr., 86399 Bobingen (DE)
(74) Vertreter: Renner, Thomas

(57) **Zusammenfassung**

Gegenstand der Erfindung ist eine Halbleiter-Schichtstruktur, beinhaltend eine monokristalline Siliciumcarbidschicht auf einer Siliciumscheibe, mit einem Durchmesser der Siliciumscheibe von wenigstens 150 mm, wobei die Siliciumcarbidschicht eine Oberflächenrauigkeit von höchstens 0,5 nm RMS und eine Micropipe-Dichte von höchstens 1 cm⁻² aufweist und darüber hinaus frei von jeglichen Defekten ist, die beim Kristallwachstum oder bei einer epitaktischen Abscheidung auftreten.

Des Weiteren betrifft die Erfindung ein Verfahren zur Herstellung einer Halbleiter-Schichtstruktur, wobei Kohlenstoffionen in eine bestimmte Tiefe einer Siliciumscheibe implantiert werden, dann die Siliciumscheibe thermisch behandelt wird, wodurch sich in der Siliciumscheibe eine vergrabene monokristalline Siliciumcarbidschicht sowie oberhalb und unterhalb der Siliciumcarbidschicht nichtkristalline Übergangsregionen ausbilden, nachfolgend die obere Siliciumschicht sowie die über der monokristallinen Siliciumcarbidschicht liegende nichtkristalline Übergangsregion abgetragen werden, wodurch die monokristalline Siliciumcarbidschicht freigelegt wird, und anschließend die freigelegte Oberfläche der monokristallinen Siliciumcarbidschicht auf eine Oberflächenrauigkeit von weniger als 0,5 nm RMS chemo-mechanisch planarisiert wird.

## Beschreibung

Gegenstand der Erfindung ist eine Halbleiter-Schichtstruktur, die eine monokristalline Siliciumcarbidschicht auf einem Siliciumsubstrat umfasst und sich als Substrat für epitaktisches Wachstum von Halbleitermaterialien eignet. Gegenstand der Erfindung ist auch ein Verfahren zur Herstellung einer Halbleiter-Schichtstruktur.

Siliciumcarbid ist aufgrund seiner Materialeigenschaften, wie hoher Schottky-Barriere, hoher Durchbruchfeldstärke und hoher thermischer Leitfähigkeit, das ideale Material für hochsperrende Leistungsbauelemente. Siliciumcarbid ermöglicht die Herstellung kleinerer, leichterer Bauelemente mit niedrigen Schaltzeiten, bei denen keine aufwändige Kühlung nötig ist, da sich die Bauelemente auch bei starker Beanspruchung nicht stark aufheizen. Außerdem eignet sich Siliciumcarbid zur Herstellung optoelektronischer Bauelemente, da seine Gitterkonstante im Gegensatz zu den Gitterkonstanten von Silicium bzw. Saphir näher bei den Gitterkonstanten von typischen Halbleitermaterialien für die Optoelektronik wie zum Beispiel Nitridverbindungshalbleitern liegt. Dies wirkt sich vorteilhaft auf die Vermeidung von Defekten während des epitaktischen Wachstums von Nitridverbindungshalbleitern auf Siliciumcarbid aus.

Durch Wachstum von Einkristallen gewonnenes Siliciumcarbid ist aufgrund des schwierigen Herstellungsverfahrens vergleichsweise teuer und die dabei erhaltenen Siliciumcarbidscheiben sind nur bis zu einem Durchmesser von 100 mm verfügbar. Außerdem treten beim üblicherweise verwendeten PVT ("Physical Vapor Transport")-Wachstum von Siliciumcarbid-Einkristallen sogenannte Micropipe-Defekte entlang der <0001> c-Achse auf (N. Ohtani in "Silicon carbide: recent major advances" / W.J. Choyke, H. Matsunami, G. Pensl (eds.), Seite 138 ff, Springer-Verlag Berlin Heidelberg 2004, ISBN 3-540-40458-9). Dabei handelt es sich um Kanäle bzw. Röhren mit Durchmessern von einigen Hundert nm bis zu mehreren µm, die entlang der c-Achse durch den Siliciumcarbid-Einkristall propagieren. In PVTgewachsenen Siliciumcarbid-Einkristallen treten Micropipes mit einer Dichte von bis zu 100 cm⁻² auf. Es wurden Versuche unternommen, die Micropipe-Kanäle beispielsweise durch Abscheidung einer bis zu 100 µm dicken epitaktischen Siliciumcarbidschicht aufzufüllen. Dadurch konnte die Micropipe-Dichte allerdings nur bis auf 10 cm⁻² reduziert werden, was unbefriedigend ist, da das Auftreten von Micropipe-Defekten im bauteilaktiven Bereich zur Zerstörung des Bauelements führt.

Heteroepitaktisches Wachstum von Siliciumcarbid auf Siliciumsubstraten führt ebenso zu Problemen, insbesondere wegen der hohen Versetzungsdichte, die auf den Gitterfehlpass mit Silicium zurückzuführen ist. Beim Wachstum von Galliumnitrid auf heteroepitaktischen Siliciumcarbidschichten ergibt sich üblicherweise eine Misfit-Versetzungsdichte von mindestens 10¹⁰ cm⁻².

Alternativ wurde der Einsatz der Ionenstrahlsynthese (IBS, "Ion Beam Synthesis") vorgeschlagen, um eine vergrabene Siliciumcarbidschicht in einem Siliciumsubstrat herzustellen. Bei diesem Verfahren werden Kohlenstoffionen mit hoher Geschwindigkeit in ein monokristallines Siliciumsubstrat implantiert und dieses nachfolgend einer Hochtemperaturbehandlung unterzogen, um eine vergrabene Siliciumcarbidschicht zu erzeugen. Die Dosis an Ionenstrahlen, die benötigte Energie, die Implantationstemperatur des Substrats und die Bedingungen der Hochtemperaturbehandlung bestimmen die Kristallinität der implantierten Region unterhalb der Oberfläche des Siliciumsubstrats. Eine monokristalline Schicht aus 3C-Siliciumcarbid (3C: Ramsdell-Notation für kubische Kristallstruktur mit Periodizität über 3 Doppelschichten) kann einige hundert Nanometer unter der Oberfläche des Substrats hergestellt werden, indem man die Dosis, die benötigte Energie, die Implantationstemperatur und die Bedingungen der Hochtemperaturbehandlung verändert. Die polykristalline Region oberhalb der kristallinen Siliciumcarbidschicht enthält eine Vielzahl an Defekten und Siliciumcarbidpräzipitate. Die vergrabene Siliciumcarbidschicht kann freigelegt werden, indem die darüber liegende Siliciumschicht entfernt wird. Die freigelegte Oberfläche besteht aus monokristallinem 3C-Siliciumcarbid und könnte prinzipiell als Substrat für epitaktisches Wachstum benutzt werden.

Allerdings hat sich gezeigt, dass die Rauigkeit der dabei erhaltenen Siliciumcarbidoberfläche zu hoch ist, um auf einem derartigen Substrat epitaktische Halbleiterschichten von hoher Qualität abscheiden zu können.

Beispielsweise wurde vorgeschlagen, die oberste Siliciumschicht durch Ätzen mit Tetramethylammoniumhydroxid (TMAH) zu entfernen (Romano-Rodriguez et al., Materials Science Forum, Vols. 338-342 (2000), pp. 309-312). Die freigelegte Siliciumcarbidoberfläche wurde dann als Substrat für epitaktisches Wachstum von Siliciumcarbid bei 1350 °C mit Silan und Propan als Quellengase und Wasserstoff als Trägergas benutzt. Die resultierende epitaktische Schicht zeigte eine hohe Dichte an Stapelfehlern. Dies liegt daran, dass TMAH eine sehr geringe Ätzwirkung auf Siliciumcarbid hat (Zetterling et al., Process technology for silicon carbide Devices, Chapter 4, ISBN 0 85296 998 8). Deshalb ist es nicht möglich, durch Ätzen mit TMAH Siliciumcarbidnanokristalliten oberhalb der vergrabenen Siliciumcarbidschicht zu entfernen. Die freigelegte Siliciumcarbidoberfläche ist rau, beinhaltet Siliciumcarbidnanokristalliten und ist damit als Substrat für epitaktisches Wachstum ungeeignet.

Auch das Ätzen der Siliciumcarbidoberfläche mit HF/HNO₃ (Flusssäure/Salpetersäure) führte zu einer rauen Oberfläche, die nicht geeignet war für qualitativ hochwertiges epitaktisches Wachstum. Dies liegt ebenfalls an den Schwierigkeiten beim Ätzen von Siliciumcarbid-Nanokristalliten an der Siliciumcarbidoberfläche.

In WO03/034484 wird vorgeschlagen, zunächst einen Teil der obersten Siliciumschicht, der mit der vergrabenen 3C-Siliciumcarbidschicht verbunden ist, zu amorphisieren. Zur Amorphisierung werden beispielsweise Heliumionen implantiert. Nachfolgend wird die vergrabene 3C-Siliciumcarbid-Schicht durch Ätzen mit HF/HNO₃ (Flusssäure/Salpetersäure) freigelegt. Die resultierende Oberfläche wird dadurch beträchtlich verbessert und eine Rauigkeit von 0,7 nm RMS (root-mean-square) erreicht. Jedoch ist selbst dieser Rauigkeitswert zu hoch für ein qualitativ hochwertiges epitaktisches Wachstum.

Die Rauigkeit einer für eine epitaktische Abscheidung geeigneten Siliciumcarbidoberfläche sollte höchstens 0,5 nm RMS betragen. Daher wurde versucht, die Siliciumcarbidoberfläche durch mechanische Politur, beispielsweise mit Diamantkorn, durch chemische Bearbeitungsschritte wie Ätzen mit sauren oder alkalischen Medien und durch chemo-mechanische Bearbeitungsschritte, also durch teilweise chemische Reaktion und teilweise mechanischen Materialabtrag (Abrasion), zu glätten.

Beispielsweise wurde vorgeschlagen, die oberste Siliciumschicht, die mit der vergrabenen Siliciumcarbidschicht verbunden ist, mittels thermischer Oxidation bei 1050 °C für eine Dauer von 40 min und nachfolgendem Abtragen des sich bildenden Oxids durch Ätzen mit einer HF/HNO₃-Lösung zu entfernen (Journal of Crystal Growth, Vol. 261, 266(2004)). Auf der freigelegten Siliciumcarbidoberfläche wurde anschließend eine 3-4 µm dicke Galliumnitridschicht epitaktisch aufgewachsen. Es zeigte sich, dass die erhaltene Galliumnitridoberfläche zwar keine Risse oder Brüche aufwies, allerdings relativ rau und für die Strukturierung von Bauelementen ungeeignet war.

Der Versuch, die raue Siliziumcarbidoberfläche durch Diamantpolieren zu glätten und somit für epitaktische Abscheidung von Halbleitermaterial vorzubereiten, führt zu bis zu 5 nm tiefen Kratzern auf der Oberfläche.

Des Weiteren wurde versucht, eine mechanisch mittels Diamantslurry vorpolierte Siliciumcarbidoberfläche mittels CMP ("Chemical Mechanical Polishing")-Politur zu planarisieren (J. Electrochem. Soc., Vol. 144, No.6, June 1997). Bei pH-Werten des CMP-Slurry oberhalb von 10, einer Temperatur von mehr als 55 °C, einer Polierzeit von etwa 30 Minuten sowie Materialabtragsraten von 0,2 µm/h wurden relativ gute Ergebnisse erzielt. Dieser hohe Materialabtrag von etwa 100 nm war nötig, um die durch die mechanische Vorpolitur verursachten tiefen Kratzer auf der Siliciumcarbidoberfläche zu entfernen. Für IBS-Siliciumcarbid ist dies jedoch ungeeignet, denn IBS-Siliciumcarbidschichten haben üblicherweise eine Schichtdicke von 50-100 nm. Damit ist der hier beschriebene CMP-Materialabtrag viel zu hoch.

Aus WO03/071588 ist ein Verfahren zur Herstellung von Halbleiterscheiben aus Siliciumcarbid bekannt, bei dem Siliciumcarbid mittels CVD (Chemical Vapor Deposition) auf einem Substrat abgeschieden, anschließend vom Substrat abgetrennt und die Siliziumcarbidoberfläche entweder durch mechanisches Polieren allein oder durch mechanisches Polieren und nachfolgende CMP-Politur sowie daran anschließendem Bestrahlen mit GCIB (Gas Cluster Ion Beam) geglättet wird. Für CMP wird ein Slurry mit einem pH-Wert von 10-11, eine Temperatur von 55 °C, Abtragsraten von 0,1-0,2 µm/h und eine Polierzeit von 12 Stunden vorgeschlagen. Dabei werden Rauigkeitswerte der Siliciumcarbidoberfläche von 0,5 nm RMS erreicht. Der CMP-Materialabtrag beträgt allerdings bei den gewählten Polierparametern 1,2-2,4 µm, was dieses Verfahren für dünne IBS-Siliciumcarbidschichten ebenfalls unbrauchbar macht.

Bei allen genannten Dokumenten des ermittelten Stands der Technik, die die Siliciumcarbidoberfläche mittels CMP zu planarisieren versuchen, ist vor CMP eine mechanische Politur vorgesehen, was aufgrund der dabei entstehenden Kratzer und des damit verbunden hohen CMP-Materialabtrags bzw. der langen Polierzeiten sehr nachteilig ist. Ein weiterer Nachteil der beschriebenen Verfahren liegt in einer erhöhten Prozesskomplexität augrund der gewählten Polierparameter begründet.

Ein anderer Ansatz wird in US 2005/0020084 A1 verfolgt. Die Siliciumcarbidschicht wird hier durch das sogenannte SmartCut-Verfahren (Layer-Transfer) erzeugt. Die Siliciumcarbidoberfläche, die zunächst eine Rauigkeit von etwa 5 nm RMS aufweist, wird mittels thermischer Oxidation bei einer Temperatur von 1000-1300 °C für 1 bis 3 Stunden auf eine Rauigkeit von 1-2 nm RMS geglättet. Anschließend erfolgt eine CMP-Politur der Siliciumcarbidoberfläche von 15 bis 30 Minuten. Der thermische Oxidationsschritt ist bei diesem Verfahren notwendig, um die eine, durch Blistering an Mikrokavitäten verursachte, zu hohe Rauigkeit aufweisende Siliciumcarbidoberfläche vorab für die nachfolgende CMP-Politur zu planarisieren. Durch diesen langen Oxidationsschritt ist dieses Verfahren allerdings relativ aufwändig und unwirtschaftlich. Mittels Layer-Transfer hergestellte Halbleiter-Schichtstrukturen werden im Folgenden nicht weiter betrachtet, da sie nicht Gegenstand der vorliegenden Erfindung sind.

Aufgabe der Erfindung war es, eine Halbleiter-Schichtstruktur, auf der sich eine epitaktische Schicht aus Halbleitermaterial, insbesondere aus einem Nitridverbindungshalbleiter, qualitativ hochwertig aufwachsen lässt sowie ein wirtschaftliches Verfahren zur Herstellung einer Halbleiter-Schichtstruktur bereitzustellen.

Diese Aufgabe wird gelöst durch eine Halbleiter-Schichtstruktur, beinhaltend eine monokristalline Siliciumcarbidschicht auf einer Siliciumscheibe, mit einem Durchmesser der Siliciumscheibe von wenigstens 150 mm, wobei die Siliciumcarbidschicht eine Oberflächenrauigkeit von höchstens 0,5 nm RMS und eine Micropipe-Dichte von höchstens 1 cm⁻² aufweist und darüber hinaus frei von jeglichen Defekten ist, die beim Kristallwachstum oder bei einer epitaktischen Abscheidung auftreten.

Der Begriff Siliciumscheibe soll in der vorliegenden Erfindung alle Silicium beinhaltenden Scheiben, die sich dazu eignen, durch Implantation von Kohlenstoff Siliciumcarbidschichten zu erzeugen, umfassen. Vorzugsweise handelt es bei der Siliciumscheibe um eine Scheibe aus monokristallinem Silicium, eine Scheibe mit einer epitaktischen Siliciumschicht, eine Scheibe mit einem SIMOX("Separation by implantation of oxygen")-Substrat oder auch eine SOI("Silicon on Insulator")-Scheibe.

Vorzugsweise handelt es sich bei der monokristallinen Siliciumcarbidschicht der erfindungsgemäßen Halbleiter-Schichtstruktur um eine durch Implantation von Kohlenstoff in eine Siliciumscheibe erzeugte Schicht.

Die erfindungsgemäße Halbleiter-Schichtstruktur weist eine Oberflächenrauigkeit von 0,05-0,5 nm RMS auf. Deshalb steht mit der erfindungsgemäßen Halbleiter-Schichtstruktur ein hochwertiges Substrat beispielsweise für die Abscheidung von Nitridverbindungshalbleitern und damit für Anwendungen in der Optoelektronik zur Verfügung.

Vorzugsweise ist auf der Siliciumcarbidschicht der erfindungsgemäßen Halbleiter-Schichtstruktur eine epitaktische Schicht abgeschieden, die einen Nitridverbindungshalbleiter beinhaltet. Vorzugsweise beinhaltet die abgeschiedene epitaktische Schicht Aluminiumnitrid (AlN), Galliumnitrid (GaN) oder Aluminiumgalliumnitrid (AlGaN). Vorzugsweise ergibt sich für die einen Nitridverbindungshalbleiter beinhaltende epitaktische Schicht auf einer erfindungsgemäßen Halbleiter-Schichtstruktur eine Versetzungsdichte von höchstens 10¹⁰ cm⁻², was eine Verbesserung gegenüber dem Stand der Technik bedeutet.

Ein besonderer Vorteil der erfindungsgemäßen Halbleiter-Schichtstruktur liegt darin, dass diese frei von jeglichen Defekten ist, die bei einer epitaktischen Abscheidung oder beim Kristallwachstum üblicherweise auftreten. Beim Kristallwachstum können das beispielsweise Defekte wie Fehlstellen, Zwischengitterplätze und Stapelfehler sein, die sich negativ auf die Leistung der darauf hergestellten Bauelemente auswirken. Bei epitaktischen Abscheidungen können sich beispielsweise Misfit-Versetzungen und Verspannungen ausbilden.

Darüber hinaus weist die erfindungsgemäße Halbleiter-Schichtstruktur eine Micropipe-Dichte von höchstens 1 cm⁻² auf. Im Stand der Technik wird bei Siliciumcarbidscheiben mit einem Durchmesser von 100 mm eine Micropipe-Dichte von 30-100 cm⁻² beobachtet, die auch durch Auffüllen der Micropipes mittels Abscheiden einer epitaktischen Siliciumcarbidschicht nur bis auf 10 cm⁻² reduziert werden kann.

Die Aufgabe wird auch gelöst durch ein Verfahren zur Herstellung einer Halbleiter-Schichtstruktur, wobei Kohlenstoffionen in eine bestimmte Tiefe einer Siliciumscheibe implantiert werden, dann die Siliciumscheibe thermisch behandelt wird, wodurch sich in der Siliciumscheibe eine vergrabene monokristalline Siliciumcarbidschicht sowie oberhalb und unterhalb der Siliciumcarbidschicht nichtkristalline Übergangsregionen ausbilden, nachfolgend die obere Siliciumschicht sowie die über der monokristallinen Siliciumcarbidschicht liegende nichtkristalline Übergangsregion abgetragen werden, wodurch die monokristalline Siliciumcarbidschicht freigelegt wird, und anschließend die freigelegte Oberfläche der monokristallinen Siliciumcarbidschicht auf eine Oberflächenrauigkeit von weniger als 0,5 nm RMS chemo-mechanisch planarisiert wird.

Der Begriff Siliciumscheibe soll alle Silicium beinhaltenden Scheiben, die sich dazu eignen, durch Implantation von Kohlenstoff Siliciumcarbidschichten zu erzeugen, umfassen.

Vorzugsweise handelt es bei der Siliciumscheibe um eine Scheibe aus monokristallinem Silicium, eine Scheibe mit einer epitaktischen Siliciumschicht, eine Scheibe mit einem SIMOX("Separation by implantation of oxygen")-Substrat oder auch eine SOI("Silicon on Insulator")-Scheibe.

Ein besonderer Vorteil des erfindungsgemäßen Verfahrens besteht darin, dass im Gegensatz zum Stand der Technik vor der chemo-mechanischen Planarisierung keinerlei Vorbehandlungen der Siliciumcarbidoberfläche wie mechanische Vorpolitur, thermische Behandlung oder thermische Oxidation vorgesehen sind. Daher ist das erfindungsgemäße Verfahren im Vergleich zum Stand der Technik besonders wirtschaftlich.

Durch die Implantation von Kohlenstoffionen in eine Siliciumscheibe, die vorzugsweise unter einem Winkel von 0-20° zu einer Oberflächennormale der Siliciumscheibe erfolgt, und die nachfolgende thermische Behandlung, die vorzugsweise bei einer Temperatur von 1050-1400 °C für eine Dauer 2-20 Stunden erfolgt, bilden sich in der Siliciumscheibe eine vergrabene monokristalline Siliciumcarbidschicht sowie nichtkristalline Übergangsregionen oberhalb und unterhalb dieser Siliumcarbidschicht. Es hat sich gezeigt, dass eine Implantation unter einem flachen Winkel zur Oberflächennormale der Siliciumscheibe die Rauigkeit der Grenzfläche zwischen der vergrabenen Siliciumcarbidschicht und der oberen nichtkristallinen Übergangsregion beeinflusst. Die Implantation unter einem flachen Winkel hat einen gewissen Glättungseffekt. Daher ist es besonders bevorzugt, die Kohlenstoffionen unter einem Winkel von 1-10° zu einer Oberflächennormale der Siliciumscheibe zu implantieren.

Die obere Siliciumschicht sowie die über der vergrabenen monokristallinen Siliciumcarbidschicht liegende nichtkristalline Übergangsregion werden anschließend entfernt, vorzugsweise mittels eines geeigneten chemischen Ätzschrittes. Dadurch wird die vergrabene monokristalline Siliciumcarbidschicht freigelegt.

Diese wird dann chemo-mechanisch planarisiert (CMP), vorzugsweise mit einem Slurry, der Kolloid-Silica(Kieselerde) beinhaltet und einer Polierzeit von vorzugsweise weniger als 30 min. Besonders bevorzugt ist eine Polierzeit von weniger als 15 min und ganz besonders bevorzugt eine Polierzeit von weniger als 5 min. Die CMP-Politur erfolgt vorzugsweise bei einer Drehzahl eines Poliertellers von 10-100 min⁻¹. Die CMP-Politur wird vorzugsweise bei einem Polierdruck von 1-14 psi durchgeführt. Ein pH-Wert des verwendeten Slurry kann durch Zugabe beispielsweise von Natronlauge (NaOH) zum Slurry eingestellt werden und beträgt vorzugsweise 8-11. Die CMP-Politur erfolgt vorzugsweise bei einer Poliertemperatur von 20-60°C.

Durch die CMP-Politur wird die freigelegte Siliciumcarbidoberfläche erfindungsgemäß bis auf eine Rauigkeit von weniger als 0,5 nm RMS geglättet. Es können niedrige Rauigkeitwerte bis 0,05 nm RMS erreicht werden. Durch das erfindungsgemäße Verfahren können damit hervorragende Substrate für epitaktisches Wachstum von Halbleiter-, insbesondere von Nitridverbindungshalbleitern hergestellt werden.

Vorzugsweise wird nach der ersten Ionenimplantation von Kohlenstoffionen und der thermischen Behandlung der Siliciumscheibe eine zweite Ionenimplantation, beispielsweise von Heliumionen, die vorzugsweise unter einem Winkel von 0-20° zu einer Oberflächennormale der Siliciumscheibe erfolgt, durchgeführt. Dadurch wird eine vergrabene Damageschicht erzeugt, die wenigstens die Grenzfläche zwischen der Siliciumcarbidschicht und der oberen nichtkristallinen Übergangsregion, jedoch nicht die gesamte Siliciumcarbidschicht umfasst. Auch in diesem Fall hat die Implantation unter einem flachen Winkel einen gewissen Glättungseffekt, der durch die erzeugte Damageschicht noch verstärkt wird. Deshalb ist bei der zweiten Ionenimplantation ein Winkel von 1-10° zu einer Oberflächennormale der Siliciumscheibe besonders bevorzugt.

Eine thermische Behandlung nach der zweiten Ionenimplantation ist nicht vorgesehen.

Anschließend werden die oberen Schichten, also Siliciumschicht, nichtkristalline Übergangsregion und Damageschicht, vorzugsweise mittels Ätzen, entfernt. Die freigelegte Siliciumcarbidoberfläche ist weniger rau im Vergleich zum Verfahren ohne zweite Ionenimplantation.

Anschließend wird die Siliciumcarbidoberfläche erfindungsgemäß mittels CMP auf eine Rauigkeit von weniger als 0,5 nm RMS planarisiert. Aufgrund der weniger rauen Siliciumcarbidoberfläche nach der zweiten Ionenimplantation, wird dies mit reduzierten CMP-Materialabträgen und -Polierzeiten erreicht.

Vorzugsweise wird auf die erfindungsgemäß auf eine Rauigkeit von weniger als 0,5 nm RMS chemo-mechanisch planarisierte Siliciumcarbidoberfläche der Halbleiter-Schichtstruktur eine epitaktische Schicht abgeschieden, die einen Nitridverbindungshalbleiter beinhaltet.

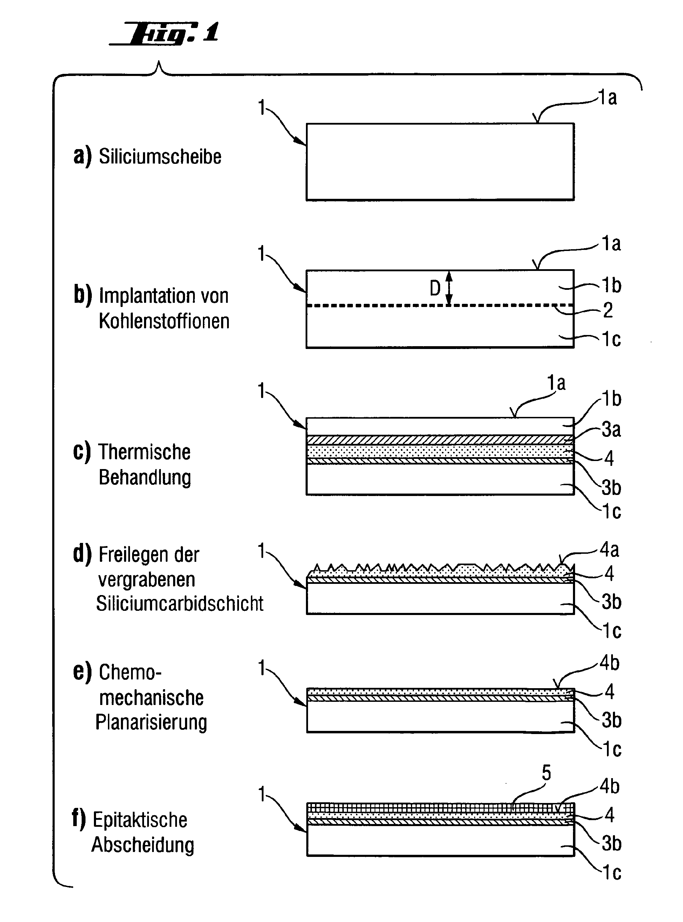

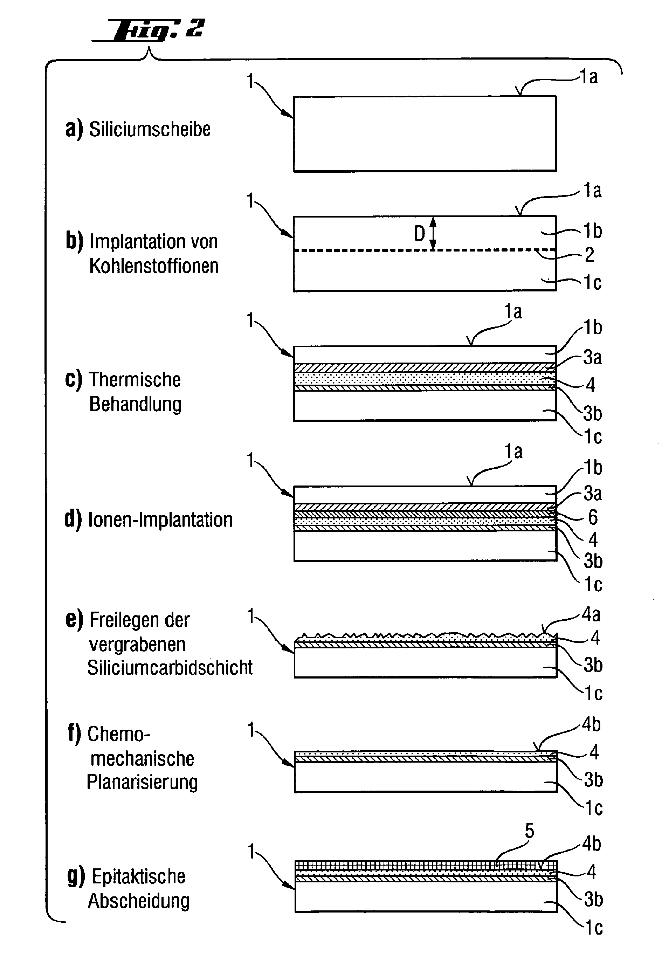

Im Folgenden wird das erfindungsgemäße Verfahren anhand von Fig. 1 und 2 erläutert.

In Fig. 1 (a bis f) wird gezeigt, wie Kohlenstoffionen 2 mit hoher Geschwindigkeit bis in eine vorbestimmte Tiefe D einer Siliciumscheibe 1 implantiert werden. Auf die Oberfläche 1a der Siliciumscheibe können möglicherweise bereits vor oder nach der Implantation andere Schichten aufgebracht worden sein oder es kann sich auch um eine Scheibe mit einer bereits strukturierten Oberfläche handeln. Die Siliciumscheibe wird nachfolgend bei hoher Temperatur thermisch behandelt. Die implantierten Kohlenstoffionen bilden zusammen mit den Siliciumatomen in der Siliciumscheibe 1 eine monokristalline Siliciumcarbidschicht 4. Oberhalb und unterhalb der monokristallinen Siliciumcarbidschicht befinden sich nichtkristalline Übergangsregionen 3a und 3b sowie Siliciumschichten 1b und 1c.

Die nichtkristallinen Übergangsregionen enthalten verschiedene polykristalline Siliciumcarbidpräzipitate, amorphes polykristallines Siliciumcarbid sowie Silicium. Die Grenzfläche zwischen der Übergangsregion 3a und einer oberen Siliciumschicht 1b sowie eine Grenzfläche zwischen der Übergangsregion 3a und der monokristallinen Siliciumcarbidschicht 4 sind relativ rau. Die obere Siliciumschicht 1b und die nichtkristalline Übergangsregion 3a werden nachfolgend entfernt, um die raue, vergrabene Siliciumcarbidoberfläche 4a freizugeben. Diese Siliciumcarbidoberfläche wird anschließend chemo-mechanisch planarisiert. Es ergibt sich eine bis auf eine Rauigkeit von 0,05-0,5 nm RMS planarisierte Siliciumcarbidoberfläche 4b. Des Weiteren wird auf der planarisierten Siliciumcarbidoberfläche 4b eine epitaktische Schicht 5 abgeschieden.

In Fig. 2 (a bis g) wird das gleiche Verfahren durchgeführt wie in Fig. 1, mit dem Unterschied, dass mit Hilfe einer zweiten Ionenimplantation, beispielsweise durch Implantation von Heliumionen, eine vergrabene Damageschicht 6 erzeugt wird, die die Grenzfläche zwischen der Siliciumcarbidschicht 4 und der Übergangsregion 3a mit einschließt, jedoch die vergrabene Siliciumcarbidschicht 4 nicht vollständig beinhaltet. Die obere Siliciumschicht 1b, die nichtkristalline Übergangsregion 3a sowie die Damageschicht 6 werden nachfolgend entfernt, um die vergrabene Siliciumcarbidoberfläche 4a freizugeben. Die Siliciumcarbidoberfläche wird anschließend chemo-mechanisch planarisiert. Es ergibt sich eine bis auf eine Rauigkeit von 0,05-0,5 nm RMS planarisierte Siliciumcarbidoberfläche 4b. Anschließend wird auf der planarisierten Siliciumcarbidoberfläche 4b eine epitaktische Schicht 5 abgeschieden.

Das Entfernen der oberen Siliciumschicht, der nichtkristallinen Übergangsregionen sowie der Defektzone kann durch Gasphasenätzen des Siliciums erreicht werden. Entweder führt man dies mit Wasserstoff, Chlorwasserstoff, Flusssäure oder einer Mischung aus genannten Stoffen bei erhöhter Temperatur durch. Die Zugabe eines Gases, das Silicium und/oder Kohlenstoff enthält, ist auch während des Ätzvorgangs möglich.

Im Fall von niederenergetischer Implantation von ca. 10 keV kann sich auf der Siliciumcarbidoberfläche ein unerwünschter, nadelähnlicher Wuchs aus Präzipitaten ausbilden (Chen et al., Applied Physics Letters, Vol. 72, Issue 15, pp. 1926-1928). Dieser nadelähnliche Wuchs wird vorzugsweise mittels eines geeigneten chemischen Ätzverfahrens entfernt. Nach der Entfernung dieses nadelähnlichen Wuchses von der Siliciumcarbidoberfläche wird diese erfindungsgemäß bis auf eine Rauigkeit von 0,05-0,5 nm RMS chemo-mechanisch planarisiert und anschließend vorzugsweise gereinigt.

Die durch das erfindungsgemäße Verfahren erreichten, extrem niedrigen Rauigkeitswerte der Siliciumcarbidoberfläche führen dazu, dass sich die hergestellten Halbleiter-Schichtstrukturen hervorragend als Substrate für epitaktisches Wachstum von Nitridverbindungshalbleitern eignen.

Siliciumcarbidsubstrate finden bei der Herstellung von optoelektronischen Bauelementen und von Bauelementen für den Starkstrombereich Anwendung. Die dünne Schicht, die durch das IBS-Siliciumcarbid gebildet wird, kann durch epitaktisches Wachstum mittels Silan und Propan als Quellengase und Wasserstoff als Trägergas vergrößert werden.

Siliciumcarbidsubstrate werden vorwiegend als Ausgangsmaterial für optoelektronische Bauelemente genutzt, wobei die Siliciumcarbidoberfläche als Substrat für epitaktisches Wachstum genutzt wird. Beispielsweise können epitaktische Schichten aus GaN (Galliumnitrid), AlGaN (Aluminiumgalliumnitrid) sowie InAlGaN (Indiumaluminiumgalliumnitrid) auf einer Siliciumcarbidoberfläche abgeschieden und dadurch optoelektronische Bauelemente sowie Bauelemente für Hochleistungs- und Hochfrequenzelektronik hergestellt werden.

Anwendungsbeispiele sind FET's (Field Effect Transistors), blaue LED's (Light Emitting Diodes) und Photodioden.

### Beispiel:

In eine Scheibe aus monokristallinem Silicium und einem Durchmesser von 150 mm wurden Kohlenstoffionen mit einer Geschwindigkeit von 180 keV, einer Dosis von 6,6×10¹⁷ cm⁻², einem Winkel von 7° zur Oberflächennormale der Halbleiterscheibe und einer Temperatur der Siliciumscheibe von 530 °C implantiert. Die Halbleiterscheibe wurde dann in einer Argonatmosphäre bei 1250 °C für 10 Stunden thermisch behandelt.

Nach der thermischen Behandlung wurden in die Siliciumscheibe Heliumionen mit einer Geschwindigkeit von 80 keV, einer Dosis von 8×10¹⁶ cm⁻² und einem Winkel von 7° zur Oberflächennormale der Siliciumscheibe implantiert.

Die oberen Schichten (Siliciumschicht, Übergangsregion und Damageschicht) wurden nachfolgend durch Ätzen mit einem HF/HNO₃-Gemisch und einem Gemischverhältnis von 1:6 innerhalb von 150 Sekunden abgetragen.

Die Dicke der freigelegten Siliciumcarbidschicht betrug 75 nm.

Die Oberflächenrauhigkeit der Schicht wurde dann mittels AFM ("Atomic Force Microscopy") gemessen. Dabei ergab sich ein Wert von 3,31 nm RMS auf einer Fläche von 1×1 µm².

Die freigelegte Siliciumcarbidoberfläche wurde anschließend mit Hilfe einer Logitech CMP-Poliermaschine chemo-mechanisch planarisiert. Für 3 Minuten kamen folgende Parameter zur Anwendung: eine ESM-13 Polierscheibe, ein Slurry auf Basis von Kolloid-Silica(Kieselerde) mit einem pH-Wert von 8 bis 11, ein Druck von 2 psi, eine Drehzahl des Poliertellers von 30 bzw. 40 min⁻¹. Das Polieren fand bei Raumtemperatur statt. Der Materialabtrag von Siliciumcarbid bei der CMP-Politur betrug 9 nm.

Die sich daraus ergebende Oberflächenrauigkeit wurde anschließend wieder mittels AFM gemessen. Es ergab sich ein Wert von 0,36 nm RMS auf einer Fläche von 1×1 µm².

## Patentansprüche

1. Halbleiter-Schichtstruktur, beinhaltend eine monokristalline Siliciumcarbidschicht auf einer Siliciumscheibe, mit einem Durchmesser der Siliciumscheibe von wenigstens 150 mm, wobei die Siliciumcarbidschicht eine Oberflächenrauigkeit von höchstens 0,5 nm RMS und eine Micropipe-Dichte von höchstens 1 cm⁻² aufweist und darüber hinaus frei von jeglichen Defekten ist, die beim Kristallwachstum oder bei einer epitaktischen Abscheidung auftreten.

2. Halbleiter-Schichtstruktur nach Anspruch 1, **dadurch gekennzeichnet, dass** auf der Siliciumcarbidschicht eine epitaktische Schicht abgeschieden ist, die einen Nitridverbindungshalbleiter beinhaltet.

3. Halbleiter-Schichtstruktur nach Anspruch 2, **dadurch gekennzeichnet, dass** es sich bei dem Nitridverbindungshalbleiter um Aluminiumnitrid, Galliumnitrid oder Aluminiumgalliumnitrid handelt.

4. Halbleiter-Schichtstruktur nach Anspruch 2 oder 3, **dadurch gekennzeichnet, dass** die epitaktische Schicht eine Versetzungsdichte von weniger als 10¹⁰ cm⁻² aufweist.

5. Verfahren zur Herstellung einer Halbleiter-Schichtstruktur, wobei Kohlenstoffionen in eine bestimmte Tiefe einer Siliciumscheibe implantiert werden, dann die Siliciumscheibe thermisch behandelt wird, wodurch sich in der Siliciumscheibe eine vergrabene monokristalline Siliciumcarbidschicht sowie oberhalb und unterhalb der Siliciumcarbidschicht nichtkristalline Übergangsregionen ausbilden, nachfolgend die obere Siliciumschicht sowie die über der monokristallinen Siliciumcarbidschicht liegende nichtkristalline Übergangsregion abgetragen werden, wodurch die monokristalline Siliciumcarbidschicht freigelegt wird, und anschließend die freigelegte Oberfläche der monokristallinen Siliciumcarbidschicht auf eine Oberflächenrauigkeit von weniger a1s 0,5 nm RMS chemo-mechanisch planarisiert wird.

6. Verfahren nach Anspruch 5, **dadurch gekennzeichnet, dass** die Implantation der Kohlenstoffionen unter einem Winkel von 1-10° zu einer Oberflächennormale der Siliciumscheibe erfolgt.

7. Verfahren nach Anspruch 5 oder Anspruch 6, **dadurch gekennzeichnet, dass** die thermische Behandlung bei einer Temperatur von 1050-1400 °C für eine Dauer von 2-20 Stunden erfolgt.

8. Verfahren nach einem der Ansprüche 5 bis 7, **dadurch gekennzeichnet, dass** die obere Siliciumschicht und die obere nichtkristalline Übergangsregion durch einen chemischen Ätzschritt entfernt werden.

9. Verfahren nach einem der Ansprüche 5 bis 8, **dadurch gekennzeichnet, dass** die chemo-mechanische Planarisierung mit einem Slurry erfolgt, der Kolloid-Silica beinhaltet.

10. Verfahren nach einem der Ansprüche 5 bis 9, **dadurch gekennzeichnet, dass** der Slurry einen ph-Wert von 8-11 aufweist.

11. Verfahren nach einem der Ansprüche 5 bis 10, **dadurch gekennzeichnet, dass** die Polierzeit weniger als 30 Minuten beträgt.

12. Verfahren nach Anspruch 11, **dadurch gekennzeichnet, dass** die Polierzeit weniger als 15 Minuten beträgt.

13. Verfahren nach Anspruch 11, **dadurch gekennzeichnet, dass** die Polierzeit weniger als 5 Minuten beträgt.

14. Verfahren nach einem der Ansprüche 5 bis 13, **dadurch gekennzeichnet, dass** die chemo-mechanische Planarisierung bei einem Polierdruck von 1-14 psi erfolgt.

15. Verfahren nach einem der Ansprüche 5 bis 14, **dadurch gekennzeichnet, dass** die chemo-mechanische Planarisierung bei einer Drehzahl eines Poliertellers von 10-100 min⁻¹ erfolgt.

16. Verfahren nach einem der Ansprüche 5 bis 15, **dadurch gekennzeichnet, dass** die chemo-mechanische Planarisierung bei einer Temperatur von 20-60 °C erfolgt.

17. Verfahren nach einem der Ansprüche 5 bis 16, **dadurch gekennzeichnet, dass** nach der Implantation von Kohlenstoffionen und der nachfolgenden thermischen Behandlung eine zweite Ionenimplantation unter einem Winkel von 0-20° zu einer Oberflächennormale der Siliciumscheibe erfolgt.

18. Verfahren nach Anspruch 17, **dadurch gekennzeichnet, dass** es sich bei der zweiten Ionenimplantation um eine Implantation von Helium unter einem Winkel von 1-10° zu einer Oberflächennormale der Siliciumscheibe erfolgt.

19. Verfahren nach einem der Ansprüche 5 bis 18, **dadurch gekennzeichnet, dass** nach der chemo-mechanischen Planarisierung der Siliciumcarbidoberfläche eine epitaktische Schicht auf der Halbleiter-Schichtsstruktur abgeschieden wird, die einen Nitridverbindungshalbleiter beinhaltet.
